# EUROPEAN PATENT SPECIFICATION

(11) **EP 3 271 139 B1**
(45) Date of publication and mention of the grant of the patent: **09.09.2020**
(21) Application number: 15712570.9
(22) Date of filing: 18.03.2015
(51) Int. Cl.: B29C 64/135, B29C 64/277

(54) **STEREOLLTHOGRAPHY MACHINE WITH IMPROVED OPTICAL UNIT**
STEREOLITHOGRAFISCHE MASCHINE MIT VERBESSERTER OPTISCHER EINHEIT
MACHINE DE STEREOLITHOGRAPHIE A UNITE OPTIQUE AMELIOREE

(43) Date of publication of application: 24.01.2018
(73) Proprietor: Costabeber, Ettore Maurizio, 36010 Zane (IT)
(72) Inventor: Costabeber, Ettore Maurizio, 36010 Zane (IT)
(74) Representative: Montevecchi, Emma
(86) International application number: PCT/EP2015/055679
(87) International publication number: WO 2016/146185

(56) References cited:
- WO-A1-2011/134515
- WO-A1-2013/093612
- DESHMUKH S ET AL: "Optomechanical scanning systems for microstereolithography (MSL): Analysis and experimental verification", JOURNAL OF MATERIALS PROCESSING TECHNOLOGY, ELSEVIER, NL, vol. 209, no. 3, 1 February 2009 (2009-02-01), pages 1275-1285, XP025839735, ISSN: 0924-0136, DOI: 10.1016/J.JMATPROTEC.2008.03.056 [retrieved on 2008-04-08]

## Description

### Technical field

The invention concerns a stereolithography machine of the type suited to make three-dimensional objects by means of a plurality of superimposed layers, in which each layer is obtained through the selective solidification of a fluid substance in the areas corresponding to the volume of the object to be produced.

### Technological background

A stereolithography machine of the known type comprises a container in which there is the fluid substance, generally a light-sensitive resin in the liquid or pasty state.

The machine comprises also a source that is generally of the luminous type and emits radiation suited to solidify the fluid substance. An optical unit provides for conveying said radiation towards a reference surface arranged inside the container, which corresponds to the position of the layer of the object to be solidified.

The three-dimensional object being formed is supported by a modelling plate, which can be moved vertically with respect to the container, in such a way as to allow the last solidified layer of the object to be arranged in a position adjacent to said reference surface.

In this way, once each layer has been solidified, the modelling plate is moved in such a way as to arrange the solidified layer so that it is again adjacent to the reference surface, after which the process can be repeated for the successive layer.

The stereolithography machines of the above mentioned type are divided in two main embodiments that are described, for example, in the Italian patent application no. VI2010A000004, in the name of the same Applicant. WO2013/093612 A1 also describes a stereolithography machine.

According to the first one of said embodiments, the reference surface is arranged so that it is adjacent to the bottom of the container, which is transparent to radiation. In this case, the fluid substance is irradiated from below and the three dimensional object is formed under the modelling plate. According to the second embodiment of the invention, the reference surface is arranged at the level of the free surface of the fluid substance. In this second case, the fluid substance is irradiated from above and the three-dimensional object is formed over the modelling plate. In both of the embodiments, the radiation can be conveyed towards the different points of the reference surface by means of different optical units of the known type. In an embodiment of the optical unit, a fixed source and a pair of galvanometric mirrors arranged in series one after the other are used to direct the light beam.

Each galvanometric mirror is motorized so that it can rotate around a respective rotation axis orthogonal to the axis of the other galvanometric mirror, so that the combination of their rotations makes it possible to direct the beam towards any point of the reference surface.

This optical unit described above offers the advantages that it allows the beam to be moved very rapidly, due to the lower inertia of the galvanometric mirrors, and that it is more reliable, due to the smaller number of mechanical components used.

Notwithstanding said advantages, the cost of galvanometric mirrors is relatively high, which considerably affects the cost of the stereolithography machine.

An optical unit based on galvanometric mirrors poses the further drawback of being relatively bulky.

The high cost and the considerable overall dimensions make the stereolithography machine including galvanometric mirrors unsuitable for any small series production, i.e. of the kind that may be required by small companies.

Furthermore, galvanometric mirrors include some mechanical components that are subject to wear and therefore limit their advantages, in particular due to the high costs of their substitution.

Furthermore, the inertia of galvanometric mirrors is not negligible and affects the speed of deviation of the light beam and therefore the overall processing time.

The Applicant has proposed a first solution to this problem, that is to find an optical unit that offers some of the advantages offered by the stereolithography machines of the known type based on the use of galvanometric mirrors and that furthermore is simpler to produce and to use than the latter. This solution is disclosed in WO 2013/093612 in the name of the Applicant, where a stereolithography machine comprising a container for a fluid substance; a source of predefined radiation suited to solidify the fluid substance; an optical unit suited to direct the radiation towards a reference surface in the fluid substance; and a logic control unit configured to control the optical unit and/or the source so as to expose a predefined portion of the reference surface, is described. The optical unit comprises a micro-opto-electro-mechanical system provided with a mirror associated with actuator means for the rotation around at least two rotation axes incident on and independent of each other, arranged so that it can direct the radiation towards each point of the reference surface through a corresponding combination of the rotations around the two axes.

However, Applicant has discovered that replacing the galvanometric mirrors with a single MOEMS which can be oriented or rotated along two axes does not solve all problems disclosed with reference to the prior art and furthermore poses further problems.

In the technical field of laser scanning, there are two types of laser scanning which can be in general performed: raster scanning and vector scanning. In raster scanning, the laser beam is scanned sequentially along a series of straight lines that are spaced apart and parallel to one another and that are relatively long (typically at least as long as the outside dimension of the part being scanned in the scanning direction); thus, the laser beam has to move in only one direction along each scan line, and the scanning system typically is arranged such that the movement along each scan line is effected by movement of a single mirror. In vector scanning, the laser beam is scanned sequentially along a series of straight lines or vectors whose lengths can vary from very short (e.g. less than 1 mm) to relatively long, and whose orientations relative to one another can vary, such that in general it requires coordinated movement of two mirrors to scan a vector. The ending point of one vector often coincides with the starting point of the next vector.

The present invention is concerned in particular with vector scanning, which has challenges that generally do not come into play in raster scanning. Applicant has found that in order to obtain a better control of the three-dimensional object to be fabricated by a stereolithography machine, vector scanning is to be used so as to obtain a more precise and accurate results. In addition, vector scanning allows a "contouring" of the three-dimensional object to be fabricated. The three-dimensional object to be fabricated is divided in a layer-by-layer process, where in each layer an external boundary or pattern is defined within which the laser has to scan and polymerize the resin. However, in order to obtain better surface characteristics, not only the "interior" of the boundary is scanned, but a contouring of the same (i.e. the laser beam spot follows the contour of the boundary of the pattern for each layer) is also preferably performed. This contouring is possible only by using vector scanning in a stereolithography machine.

For this type of stereolithography machines in which vector scanning is selected, a single MOEMS system movable or rotatable along two different axes is not preferred. Such a mirror has a too big inertia momentum to be moved at relatively high velocities. This lower the production time. Further, the double axes MOEMS mirror has an intrinsic limitation in the size of the mirror itself, due to the fact that it has to be moved around two incident axes. Therefore also the size of the laser spot suffers from constraints, increasing the costs of the stereolithography machine.

According to a first aspect, the invention relates to a stereolithography machine comprising:
- a container for a fluid substance suited to be solidified through exposure to predefined radiation;
- a laser source apt to emit a beam of said predefined radiation;
- a vector scanning optical unit configured to perform a vector scanning of a reference surface arranged inside said container according to a desired vector data image by means of said predefined radiation;
- a memory to store said vector data image representative of an image to be scanned on said reference surface;
- a logic control unit configured for controlling said vector scanning optical unit and/or said laser source in such a way as to expose a predefined portion of said reference surface to said radiation according to said vector image;
**wherein** said vector scanning optical unit comprises a first and a second micro-opto-electro-mechanical systems (MOEMS) arranged in series one after the other with respect to a travelling path of said predefined radiation, each MOEMS system comprising:
- a mirror having a diameter comprised between about 2 mm and about 8 mm associated with a supporting structure through articulation means configured so as to define for said mirror a rotation axis (X1, X2);
- an actuator suited to move said mirror around said rotation axis (X1, X2) in a quasi-static manner and at an angular speed so that a corresponding marking speed of said laser beam on said reference surface is comprised between about 0.5 m/s and about 3 m/s when said laser source is emitting said predetermined radiation during said vector scanning;
   and wherein
- the rotation axis of the mirror of the first MOEMS system is not parallel to the rotation axis of the mirror of the second MOEMS system.

That is to say that the first and second micro-opto-electro-mechanical systems (MOEMS) are arranged with respect to the laser source and to the container in such a way that the laser beam of predefined radiation, incident on the first and second mirrors in sequence, can be directed at points of the reference surface through a corresponding combination of the rotations of said mirrors around said two incident axes to perform the vector scanning according to said vector data image.

The vector scanning optical unit in the stereolitography machine of the invention comprises two MOEMS mirrors each moved by an actuator around an axis. Each MOEMS mirror is rotatable around a single axis only. Preferably, the actuator of each mirror is either of the electrostatic actuation type or of the electromagnetic actuation type. Both these actuations are known in the art and not further detailed in the following. Each MOEMS mirror has a single axis of rotation, but the axis of rotation of the first MOEMS mirror is incident to the axis of rotation of the second MOEMS mirror, that is the two axes are not parallel to each other. A laser beam emitted by a laser source is reflected by the MOEMS mirrors one after the other in series and then onto the working surface (reference surface) of a material in the stereolithography machine, "drawing" a beam trajectory. During this trajectory, the radiation of the laser beam illuminates a portion of the liquid to which the reference surface belongs, so that such portion becomes "harder" (polymerized or cured). The reference surface is thus the "working layer" which is solidified according to a given pattern or image. A plurality of working surface or layers need to be patterned in order to form a 3-dimensional object. For example, the two MOEMS mirrors are positioned above the reference surface and the focused laser beam proceeds vertically downward onto the working surface. Advantageously, the two MOEMS mirrors are arranged so that they move the laser beam, which forms a "spot" onto the reference surface, in two orthogonal directions. This vector scanning is performed onto all surfaces, or layers, separated one from the other by a distance along a third axis, such as the vertical axis Z, preferably perpendicular to both the rotation axes of the MOEMS mirrors, so as to form a 3 dimensional object. Each surface or layer is vector scanned according to a different vector data image, according to a technique known in the art of the 3-dimensional printing to realize the 3-dimensional (3D) object.

A vector data image which defines the pattern to be scanned by the laser beam is a file, processed by a computer or processor, such as a CAD file (for example the CAD programs realize a .stl file), where the information about the image to be scanned in the working surface are contained. The vector image defines a contour or boundary which is the outer or external boundary of the image and an "interior" to the boundary where the laser beam has to pass ("scan") in order to solidify the liquid from which the 3D object is to be realized.

According to the invention, as mentioned, the laser beam is scanned by means of the vector scanning optical unit which includes two MOEMS systems. MOEMS or Micro-Opto-Electro-Mechanical Systems include MEMS merged with Micro-optics which involves sensing or manipulating optical signals on a very small size scale using integrated mechanical, optical, and electrical systems. These devices are usually fabricated using micro-optics and standard micromachining technologies using materials like silicon, silicon dioxide, silicon nitride and gallium arsenide, etc. MOEMS includes two major technologies, MEMS and Micro-optics. MEMS - Microelectromechanical - systems is the technology of very small devices. Preferably, MOEMS are fabricated using the process technology in semiconductor device fabrication, such as for example deposition of material layers, patterning by photolithography and etching to produce the required shapes.

Preferably, the MOEMS mirrors of the present invention are reflecting mirrors, more preferably realized in silicon. Preferably, the MOEMS mirrors in the scanning unit of the invention are realized using CMOS technology.

As mentioned, the Applicant is interested only in a vector scanning optical unit, for the advantages above mentioned.

The selection of two MOEMS mirrors movable each along a single axis instead of a single MOEMS mirror movable or rotatable along two axes lie in the fact that the efficiency of the two single-axis MOEMS mirrors is higher than the efficiency of a single MOEMS mirror rotatable around two axes. In a two-axes MOEMS mirror, part of the area of the "object" defining the mirror is dedicated to the axial movement. Therefore, for the same area occupied, in a two axes MOEMS mirror the effective size of the mirror on which the laser beam can impinge is smaller than in the case of a single-axis MOEMS mirror. In addition, a two-axes MOEMS mirror is heavier than a single-axis MOEMS mirror, thus having a higher angular inertia. Further, the dimensions of single-axis MOEMS mirrors are better controllable and its rotation is more stable, which are relevant parameters for the present invention as detailed below.

Applicant has also realized that, in order to obtain a vector scanning optical unit using two single-axis MOEMS mirrors, a "quasi-static" motion of each of the MOEMS mirrors is to be imposed.

MOEMS mirrors can be divided in two classes: resonant MOEMS mirrors and quasi-static (sometimes also called static or steering mirrors in the literature) MOEMS mirrors. Normally, a MOEMS mirror is mechanically designed to work in either a quasi-static or in a resonant mode. Resonant MOEMS mirrors are mirrors which are actuated at a resonant frequency. Resonant frequency is a frequency at which a body shows a very large reaction (amplitude motion or oscillation) for a low excitation level. For the MOEMS mirror, it is the frequency at which the scanning amplitude is maximal for a given actuation level.

Quasi-static MOEMS mirror means that the mirror is actuated far from its mechanical resonant frequency, and therefore the relation between the scanning angle and the actuation signal is substantially linear. A quasi-static MOEMS mirror is a mirror that is actuated in the linear region where there is a linear relationship between an actuating signal (e.g. a voltage signal) and an angular displacement around the single axis around which the quasi-static MOEMS mirror is rotatable. Thus - known the angular position at which the MOEMS mirror is to be put, and which has to be hold, the mirror can be driven to hold such specific position by applying a certain continuous actuation signal. Typically, the quasi-static mode operation goes from static (tilt the mirror and hold a position) up to several hundreds of Hz. In this frequency range, the mirror will follow the actuation signal shape. The Resonant actuation mode is the mode where the MOEMS mirror is actuated with a signal frequency equal to the resonant frequency of the mirror. Because the mirror scanning amplitude is amplified at mechanical resonant frequency, the mirror motion will act as a mechanical oscillator and then will follow a sinusoidal motion (and not a linear motion).

Applicant has realized that to obtain the precise control needed to vector scan the image contained in the image vector data file, two quasi-static MOEMS mirrors have to be used, so that the control unit can send a predetermined voltage signal to which a precise angle at which the two MOEMS mirrors are tilted around the X1 and X2 axes, respectively, correspond, depending on the linear characteristic of the MOEMS mirrors used.

In this way, a precise control is possible, to a signal or to a couple of signals sent by the actuators (signal derived by a corresponding signal emitted by the control unit) to the first and the second MOEMS mirrors, a first and a second angles at which the two MOEMS mirrors become positioned are associated (each MOEMS mirror is tilted at a specific angle around its axis, X1 or X2, the value of which is determined by the signal send by the actuator/control unit), so a precise spatial point within the reference surface to be scanned is associated as well to such a signal or couple of signals.

Due to the fact that a vector scanning is performed, complex paths or trajectories can be obtained guiding the laser beam onto the reference surface by the scanning optic according to the image present in the image data. The time for scanning a given path onto the reference surface by the laser beam from a first point to a second point depends on the angular velocity of the MOEMS mirrors, that is on their velocity to change their positions (i.e. angles) at which the first point is associated into new positions (i.e. new angles) to which a new point in the reference surface is associated, so that from the first point the beam is moved towards the second point with a given velocity. Not all velocities can be used, due to the following.

In raster scanning, due to the "high speed" of the mirrors and thus of the "high speed" of the beam onto the surface, the laser beam normally scan the same portion(s) of the surface more than once, because it scans the portion of surface in "lines" one substantially parallel to the others at high speed. For this type of scanning, either the laser source is extremely powerful - which is generally avoided - or to properly solidify the liquid in the container more than a laser passage is needed.

Applicant has realized that in vector scanning applied to a stereolithography machine an optimal solution to balance the requirements for a rapid execution of the scanning on one hand and to limit as much as possible to one (or only very rarely to more than one) "solidification" of the same portion of image (that is, the laser "draws" the same pattern only once) on the other hand, a specific angular velocity range for the movements of the single-axis MOEMS mirrors is selected. Indeed, more powerful laser sources could work also with mirrors moved at higher velocities, however the stereolithography machine of the invention is directed to the relatively "low price" market, where high power expensive lasers are preferably not used. The angular velocity of the MOEMS mirrors is thus selected in such a way that the "sweeping" speed of the laser beam onto the working or reference surface is comprised in an interval for which polymerization or solidification is possible in a single "sweep" of the laser beam along a given pattern.

Using this specific angular velocity according to the invention of the mirrors, the corresponding laser velocity of the laser beam in the reference surface is comprised between about 0.5 m/s and about 3 m/s when said laser source is performing the vector scanning, for which the desired compromise between precision, solidification in substantially a single "drawing" with the laser beam and manufacturing speed is obtained. That is, the mirrors are actuated in such a way that they move at an angular velocity for which the corresponding laser beam velocity is within the interval 0.5 m/s - 3 m/s. This laser velocity onto the reference surface depends on the distance between the scanning optic and the surface itself and on the angular velocity of the MOEMS mirrors. Given the desired laser velocity onto the reference surface, that is the velocity of the laser beam moving onto the reference surface, the man skilled in the art can derive the angular velocity at which the MOEMS mirrors have to be tilted, depending on the construction characteristics of the stereolithography machine. This "sweeping" velocity is called "marking velocity", which indicates the velocity at which the laser beam is scanning the reference surface of interest and performing the hardening of the liquid included in the container.

Still to keep the price of the stereolithography machine of the invention relatively low, also the dimensions of each of the single-axis MOEMS mirrors of the first and second MOEMS system is relevant. Too broad mirrors cause the realization of a bulky machine and instability of the mirrors themselves. In some cases, the mirrors can be relatively large and accordingly can have substantial mechanical inertia. Consequently, it can take a considerable period of time to accelerate the scanning mirrors to their full desired speed. It has been found that ignoring the finite acceleration period of the mirrors can in some cases lead to unacceptably large following errors of the laser spot.

Too small mirrors' dimensions impose strict limitations onto the radiation beam which has to be used end emitted by the laser source. Applicant has thus found that in this case a suitable compromise is a MOEMS mirror diameter comprised between about 2 mm and about 8 mm. In the present context the term "diameter" is referred to not only the circular mirrors, but also to other mirrors' geometrical shapes. On this latter case, the diameter is the largest dimension in a direction perpendicular to the rotation axis of the MOEMS mirror.

This dimensions of the MOEMS mirrors are adapted to the velocity which has been selected, that is are selected taking also in consideration that these MOEMS mirrors have to move so that the laser beam velocity onto the reference surface is to be comprised between about 0.5 m/s and about 3 m/s without difficulties.

The invention, according to the above mentioned aspect, may include, either as alternatives or in combination, one or more of the following characteristics.

Advantageously, said actuator is configured to move said mirror of said first and/or said second MOEMS systems around said rotation axis (X1, X2) at an angular speed so that a corresponding positioning speed of said laser beam on said reference surface is comprised between about 8 m/s and about 10 m/s when said laser source is not emitting said predetermined radiation to change position in said reference surface for the scanning of said image.

The image to be scanned and saved in the file can form a continuous shape, that is a single form confined within a single closed boundary, or a plurality of separated shapes delimited by separated closed boundaries. In order for the laser beam to scan the different separated shapes, the beam should move from one position to another, often relatively distant position, to start the scanning again. The distance between the various shapes can be long enough that requires a repositioning of the MOEMS mirrors. Therefore, in the process of repositioning and moving from a first portion of the shape(s) to be scanned to another second portion of the shape to be scanned distant from the first one, the laser is switched off and the MOEMS mirrors are moved. This movement of repositioning is performed at a speed which is preferably higher than the angular speed corresponding to the laser speed at which the "sweeping" of the laser is performed - the marking speed - and more preferably this angular speed is such that the corresponding velocity at which the laser beam moves between the last point on the reference surface at which the laser is switched off and the new point on the surface at which the laser is switched on again is comprised between about 8 m/s and about 10 m/s. In other words, the repositioning speed is calculated as if the laser beam is not switched off. This speed of the laser beam on the reference surface is called "positioning speed" and it is the speed of the laser beam between these two points "as if" the laser were continuously on. However, the laser beam is switched off to avoid polymerization of portions of the surface which should not be subjected to laser radiation.

As for the marking speed, the positioning speed of the laser depends on the angular speed on the mirrors and on the distance between the scanning optic and the reference surface.

Advantageously, said two rotation axes (X1, X2) of said first and second micro-opto-electro-mechanical systems are mutually orthogonal.

That is, preferably the mirror of the first MOEMS system rotates around an X axis and the mirror of the second MOEMS system rotates around a Y axis so that the combination of rotations of the two mirrors allows the laser beam to reach any position in the (X,Y) surface of the liquid material.

In a preferred embodiment, said laser source is configured to emit said predefined radiation at a wavelength comprised between about 405 nm ± 10 nm.

Different laser sources can be used in a 3D printing machine. In the present invention, a rather "unusual" wavelength of the laser source is used, that is a laser source capable of emitting in the violet region. This laser is classified as a "blue" laser. Lasers at this wavelength are generally cheaper than lasers suitable to emit a radiation beam at a different wavelength still within the UV range. Further, also coatings of mirrors for the optic are also cheaper when they have to work with an impinging radiation at this claimed wavelength.

Preferably, said laser source is configured to emit said predefined radiation having a irradiance at the reference surface comprised between about 10 mJ/cm² and about 200 mJ/cm².

As mentioned, the power of the laser beam at such predefined radiation should be high enough to polymerize the liquid material so that it becomes solid where it is scanned, i.e. subjected to the laser beam radiation, and not so high that the cost of the laser source becomes too high to hinder commercialization of a 3D printer including such an expensive laser. Applicant has found that the range of claimed powers are a good compromise taking into account the two opposite needs. However, preferably not the power, but the irradiance is regulated and fixed. The quantity of light at the reference surface in the container is defined in either intensity units or energy units. Light intensity at the reference surface, described by the term irradiance, is a measure of momentary exposure, which is the relevant value for determining whether this value of the power of the laser can polymerize the liquid included in the container.

In a preferred embodiment, the stereolithography machine according to the invention includes a sealed container housing said laser source and said first and second micro-opto-electro-mechanical systems (MOEMS) arranged in series, said sealed contained including a windows realized in a material transparent to said predetermined radiation so that said radiation can exit said container.

Applicant has discovered that the laser radiation, in particular laser radiation at the claimed wavelength of about 405 nm ± 10 nm, may cause a potential problem due to "dirt" or to any foreign material which may deposit onto the MOEMS mirrors. These foreign particles or material, which can be simply dust, at the wavelengths of interest cause the accumulation of electrostatic charges that may enhance the temperature of the MOEMS mirrors themselves till a damage of the MOEMS mirror(s) takes place. This damage can be avoided by a cleaning of the mirror(s), however the dimensions and technical characteristics of the MOEMS mirrors do not allow a simple and easy cleaning of the same. Therefore, Applicant has preferably realized a sealed container around the laser source and the MOEMS mirrors so that foreign particles cannot deposit accidentally onto the mirrors, being blocked by the container's sealing walls.

Advantageously, said actuator of each one of said micro-opto-electro-mechanical system (MOEMS) is electromagnetic or electrostatic and is configured so as to rotate said mirror around said axis (X1, X2) in such a way as to arrange it in an angular position in response to the reception of a control signal emitted by said logic control unit and having a value that is representative of said angular position.

The actuator is commanding the mirror and fixing the angle at which they have to be rotated. As mentioned they are preferably of the electromagnetic or of the electrostatic type.

Preferably, said logic control unit is configured so as to move said mirror of both said first and second micro-opto-electro-mechanical systems so that the point of incidence of said radiation on said reference surface defines a continuous trajectory that completely covers said predefined portion according to said image data.

It has to be understood that the vector data image for each layer of the 3D object can be formed by a single portion delimited by a closed boundary or by multiple separated portions. In this latter case, moving from one portion to a separated one, the laser is switched off. The laser draws the pattern only where the resin has to be polymerized: then it can "jump" at the positioning speed, being switched off, from two separated portions of the vector image to be polymerized. This process is faster than raster scanning because there is no need of "sweeping" portions not to be polymerized of the image.

Preferably, said optical unit comprises at least one lens configured so as to focus said radiation on said reference surface.

More preferably, said at least one lens comprises a flat field scanning lens.

A flat field scanning lens is a specialized lens system in which the focal plane of a deflected laser beam is a flat surface.

Advantageously, said fluid substance includes a curable resin. More preferably, this resin includes (meth-)acrylated monomers and/or oligomers. Even more preferably, such resin comprises additionally a photoiniziator, and/or a colorant and/or a fillers.

This curable resin having these characteristics works particularly well when cured using a laser having an emission in the wavelength range above claimed (e.g. about 405 nm ± 10 nm).

Advantageously, said laser source includes a power control to vary a power of said predefined radiation emitted by said laser source, said power control being connected to said logic control unit, said logic control unit being apt to change said emitted power depending on a position of said radiation beam on said reference surface.

It is generally desired to deliver a predetermined exposure (i.e., energy per unit area) pattern on the reference surface. In the simplest case, the preferred exposure pattern is constant exposure inside the boundaries delimiting the image to be scanned and zero exposure outside these boundaries. In many practical cases, however, the preferred exposure pattern is not a uniform pattern. For example, higher exposure at the boundaries of exposed area will be often beneficial. For this purpose, it is desired to regulate the laser power by means of a laser power control so as to achieve the optimum exposure as closely as possible.

The laser power control controls the irradiance of the laser beam at the reference surface, so that it is kept comprised between about 10 mJ/cm² and about 200 mJ/cm² In addition, in the "center" of the pattern to be scanned, the irradiance of the laser beam it is preferably different than at the boundaries of the same.

In a preferred embodiment, said power control includes a size control to vary a size of a beam of said predefined radiation emitted by said laser source, said size being measured in a cross-section along a plane perpendicular to a travelling direction of said radiation.

The beam size is preferably changed depending on the size of the image to be scanned, or on the size of parts of the image (for example the image may include parts having a very small dimension in one direction). The power and the size of the laser beam are controlled together, the higher the power, the bigger the size of the beam. Scanning the whole image with a laser beam of a very small size requires a long processing time. Therefore, it is preferred to change the dimension of the beam by means of a beam size controller.

### Brief description of the drawings

Said objects and advantages, together with others that are highlighted below, will be evident from the following descriptions of some preferred embodiments of the invention that are provided by way of non-limiting examples with reference to the attached drawings, wherein:
**Figure 1** shows a stereolithography machine realized according to the invention;
**Figure 2** shows a detail of the stereolithography machine shown in Figure 1;
**Figure 3** shows another view of the stereolithography machine of Figure 1; and
**Figure 4** shows a graph of the linear portion of the response (tilting angle) of a MOEMS mirror used in the invention to an applied voltage.

### Detailed description of preferred embodiments of the invention

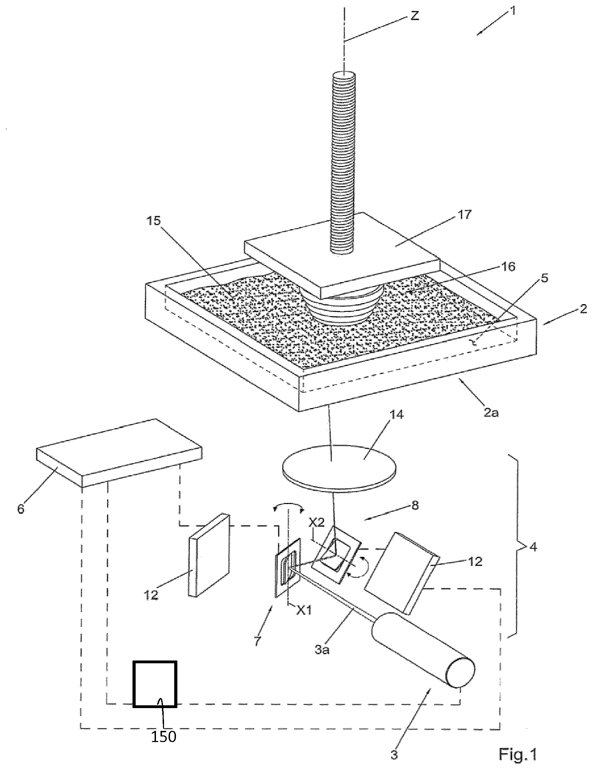

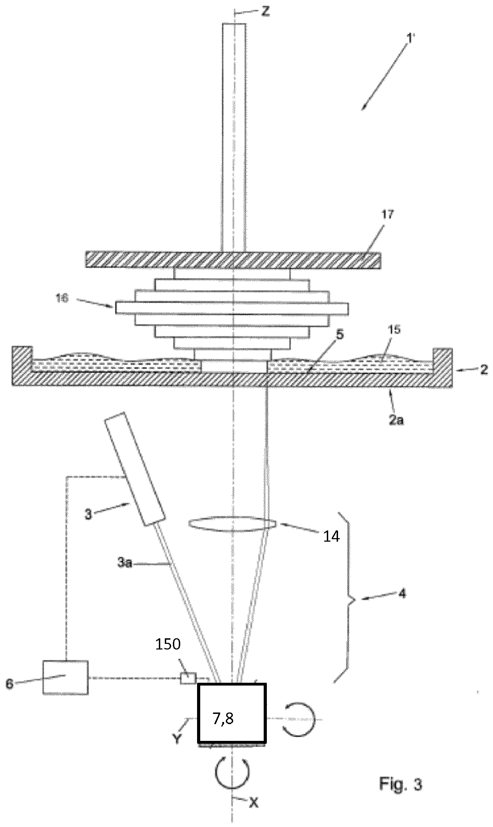

The stereolithography machine that is the subject of the invention, indicated as a whole by 1 in Figure 1 and 3, makes it possible to produce a three-dimensional object 16 through a process according to which a plurality of layers (visible in figure 3) are superimposed on one another, said layers being obtained through selective exposure of a fluid substance 15 to predefined radiation 3a suited to solidify it.

Preferably, said fluid substance 15 is a light-sensitive liquid resin. Preferably, this resin is a polymeric resin which is curable using a radiation in the UV range. Preferably the resin includes:
(meth-)acrylated monomers and/or oligomers further comprising plus photoiniziator(s), and/or colorant(s) and -in some cases- filler(s).

The radiation to expose the fluid substance is emitted by a laser source 3, preferably emitting a radiation in the wavelength range of the violet wavelength (e.g. 405 nm ± 10 nm). The resin above mentioned is solidified when the laser beam at a given irradiance is impinged on it. Preferably, the curing of the substance or resin 15 takes place for an irradiance comprised between about 10 mJ/cm² and about 200 mJ/cm².

The stereolithography machine 1 comprises a container 2 for said fluid substance 15 and a modelling plate 17 suited to support the object 16 being formed and motorised so that it moves according to a vertical movement axis Z.

The machine 1 furthermore comprises a vector scanning optical unit 4 suited to direct the radiation 3a emitted by the laser source 3 - that is to direct the laser beam - towards any point of a reference surface 5 arranged inside the container 2, at the level of the volume occupied by the fluid substance 15.

Preferably, said reference surface 5 defines a plane and is arranged so that it is adjacent to the bottom 2a of the container 2.

In this case, the vector scanning optical unit 4 is configured in such a way as to direct the predefined radiation 3a from bottom to top, so that it is incident on the bottom 2a. Furthermore, the bottom 2a is preferably transparent to the radiation 3a so that the latter can hit the fluid substance 15 located in proximity to the bottom itself so as to solidify said fluid substance 15. According to this embodiment of the invention, the three-dimensional object 16 is made under the modelling plate 17, as can be seen in Figure 1.

According to a variant embodiment of the invention (see figure 3) the optical unit 4 is configured in such a way as to direct the radiation 3a from top to bottom on the free surface of the fluid substance 15 present in the container 2. In this case, the object is made over the modelling plate 17.

In operation, the machine 1 involves formation of coatings of the resin (layers) and the solidification in specific parts of these layers to form an object, in particular a 3D object. The process may be viewed as beginning with the platform 17 immersed one layer thickness below the upper surface of the resin. The coating of resin is then polymerized according to a predetermined pattern by the laser beam emitted by the source 3. This initial layer corresponds to the initial cross section of the 3D object to be formed. After the initial formation of the desired pattern in this first layer, the platform 17 is moved along the Z axis and a new amount of layer thickness of resin is formed. After formation of this new layer, a new exposure takes place and so on, according to a different pattern.

The position of the laser beam 3a emitted by the laser source is determined by a control circuit 6, which might be for example a computer which in turn controls the vector scanning optical unit 4 which is included for controlling the direction of the laser beam 3a as it impinges target or reference surface 5. In this preferred embodiment of the invention, control unit 6 includes a controlling microprocessor for scanning optic 4 and further includes a system for storing a data base, in slice-by-slice form, to define the dimensions of the 3D object being produced. This database includes image files, such as files formed by CAD program, where the pattern or images to be created in the different cross-sections or layers are stored. A conventional personal computer workstation, such as a personal computer, is suitable for use as control unit 6 in the preferred embodiment of the invention. Control unit 6 generates signals to direct laser beam 3a, by means of the optical unit 4, across target surface 5 according to the cross-section of the 3D object to be produced in the current layer.

The control unit 6 is preferably operated by software that operates on the control unit 6 itself and which for example may also control the movement of the platform 17 on the Z direction.

In addition, control unit 6 generates signals to a laser power control system 150 to indicate the desired level of power to be delivered by laser source 3a when on, in particular the desired irradiance on the surface 5 in order to cure the resin therein contained. Further, it preferably also generates signals indicating the times at which laser source 3 is to be turned on or off according to the data base representation of the slice of the 3D object for the current layer of resin. According to the preferred embodiments of the invention, the control unit 6 controls laser power control system 150 to produce a time-varying signal to laser 3 corresponding to the instantaneous power to be delivered. The control can be an analogic control or by means of a Pulse-Width-Modulation control. The scanning optics 4 and the laser power control system 150 according to the preferred embodiments of the present invention control the vector scanning of the laser beam and the power of the laser source 3 to achieve a desired exposure of the resin to the laser energy.

Further, laser power control system 150 controls a size of the laser beam 3a, emitted by laser source 3. Preferably, laser power and laser beam size are controlled not independently, i.e. the power of the laser beam affects also the size of the laser beam, preferably in a proportional manner,

According to the invention, the vector scanning optical unit 4 comprises a first and second micro- opto-electro-mechanical systems 7 and 8 that in the field of integrated circuit technology are known with the acronym "MOEMS". As is known, MOEMS devices are made using the same technology used in microelectronics for the production of integrated circuits, for example through solid deposition, photolithography, engraving etc.

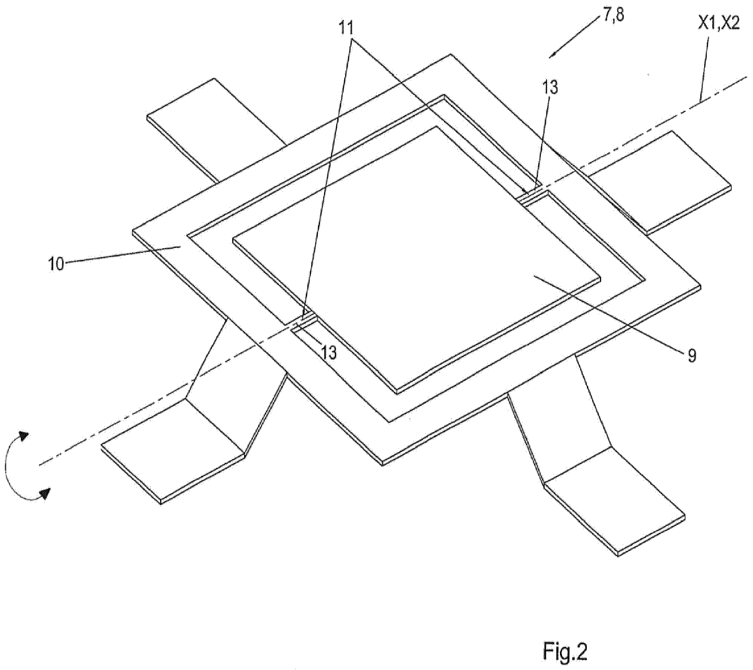

Each one of said first and second micro-opto-electro-mechanical systems 7 and 8, a possible embodiment of which is schematically represented in Figure 2 by way of example without limitation, comprises a micro mirror 9, preferably a reflective mirror, associated with a supporting structure 10 through articulation means 11 configured so as to define for each micro-opto-electro-mechanical system 7 and 8 a rotation axis X1 and X2 (such as perpendicular axes X and Y) of the mirror 9 with respect to the structure 10.

As can be observed in Figure 1, said two micro-opto-electro-mechanical systems 7 and 8 are arranged in series one after the other, so that the radiation 3a originating from the laser source 3 is incident in sequence on the mirror 9 of the first micro-opto-electro-mechanical system 7 and on the mirror 9 of the second micro-opto-electro- mechanical system 8.

According to the invention, the two micro-opto-electro-mechanical systems 7 and 8 are arranged with respect to the laser source 3 and to the container 2 in such a way that the radiation 3a, originating from the second one of said micro-opto-electro-mechanical systems 8, can be directed towards each point of said reference surface 5 through a corresponding combination of the rotations of both the mirrors 9 around the respective axes X1 and X2.

In particular, the two micro-opto-electro-mechanical systems 7 and 8 are arranged between the source 3 and the reference surface 5, in such a way that the two rotation axes X1 and X2 are preferably orthogonal to each other.

Each one of said two micro-opto-electro-mechanical systems 7 or 8 furthermore comprises an actuator 12, of the type known per se, suited to move the mirror 9 around its own axis X1 or X2 in an independent manner with respect to the movement of the mirror 9 of the other micro-opto-electro-mechanical system 7 or 8.

Said actuators 12 are preferably of the electromagnetic or electrostatic type.

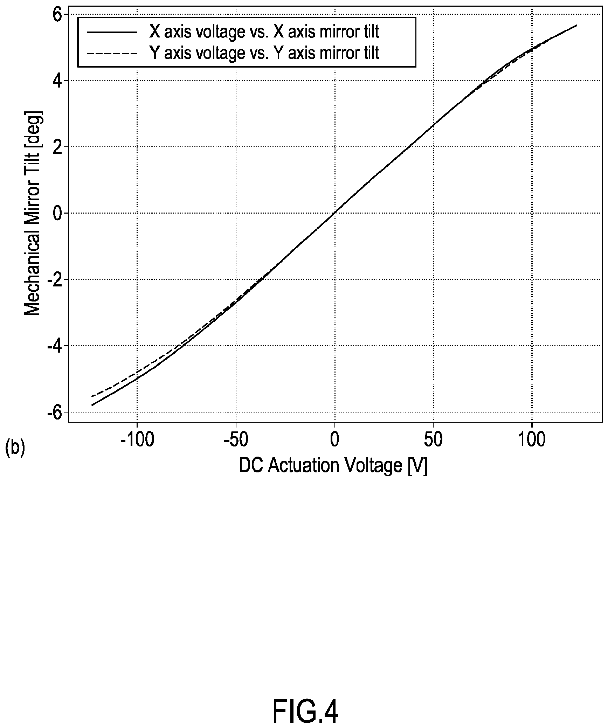

Actuators 12 are controlled by control unit 6, to set in particular the position, that is the angle, at which mirrors 9 have to be tilted in a quasi-static manner. Further, the actuators 12 are controlled by control unit 6 so that the movement - or angular velocity - they impose onto the mirrors 9 around their respective rotation axes X1 and X2 is determined according to the data of the pattern to be realized by the laser beam and stored in the data base, such as the vector data file. This angular velocity at which the mirrors 9 are commanded to move is such that the velocity of the laser beam onto the surface 5 during the vector scanning is comprised between about 0.5 m/s and about 3 m/s, preferably about 1.5 m/s and about 2.5 m/s. Further, the actuators 12 are such that they control the mirrors 9 in such a way that each movement of the mirrors 9 is performed in the linear region of the working space of the mirrors themselves. As shown in figure 4, each mirror 9, when subjected to a voltage signal, tilts with respect to its rotational axis X1 or X2 depending on the value (magnitude) of such voltage signal. That is the tilt amplitude is linearly dependent to the voltage amplitude of the commanding signal. In order to work in the quasi-static regime, the actuators send signals to the mirrors so that they work in the working space where there is a linear correspondence between the voltage amplitude and the angle at which the mirror tilts.

As regards the actuator 12 that sets the mirror 9 of each one of said micro-opto-electro-mechanical systems 7 and 8 moving, it is configured so that it rotates said mirror 9 around the axis X1 or X2 based on the value of a control signal sent by the logic control unit 6 and representing the angular position that the mirror 9 has to assume.

Each mirror 9 of the first and second MOEMS systems 7, 8 has a dimension along an axis perpendicular to their respective rotation axes X1 and X2 comprised between about 2 mm and about 8 mm and preferably of about 2.5-4.5 mm.

Preferably, the mirror 9 and the supporting structure 10 of each one of the micro-opto-electro-mechanical systems 7 and 8 are obtained in a single piece and are connected to each other through corresponding connection areas 13 belonging to the articulation means 11 and thin enough to yield elastically according to the rotation axis X1 or X2, in such a way as to allow the rotation of the mirror 9 with respect to the supporting structure 10.

In particular, each one of said connection areas 13 works as a torsion spring that can be deformed to a degree that depends on a pilot voltage of the device.

Obviously, in variant embodiments of the invention, the rnicro-opto-electro-mechanical systems 7 and 8 can be made in any shape, provided that for each one of them the corresponding mirror 9 can rotate around an axis with respect to the supporting structure 10. In particular, the logic control unit 6 is configured in such a way as to move both the mirrors 9 of the two micro-opto-electro-mechanical systems 7 and 8 in such a way that the laser radiation 3a falls inside the predefined portion corresponding to the layer of the object 16 to be made, according to the vector data in the database, following one or more continuous trajectories.

The control unit 6 commands the actuators 12 to move the mirrors 9 in a quasi-static manner, that is the vector scanning unit moves the mirrors so that the laser beam performs "vector" paths in the surface 5 and the relationship between the signal sent and the angle at which the mirrors are positioned is substantially linear.

Preferably but not necessarily, said movement takes place according to a single continuous trajectory that entirely covers the predefined portion of the surface 5.

The laser source 3 is switched on and illuminates the surface 5 only inside the boundaries of the patterns or image(s) to be polymerized according to the vector data image file. The laser beam 3a moves according to "vectors", that is trajectories, onto surface 5. The laser source 3 is on only when such trajectories meet portions of resin to be polymerized, i.e. resins included within the boundaries of the parts of surface 5 to be solidified. Outside these regions or parts to be polymerized, the laser is switched off, that is if the laser has to be repositioned and the laser beam would sweep during the repositioning in areas of the surface 5 not to be polymerized, it is preferred that the laser is switched off.

The power of the laser source 3 is increased inside the boundaries of the parts or portions to be polymerized according to the vector data image. Such increase in power generally implies an increase in the dimensions of the laser beam itself, that is in the dimensions of the cross-section along a plane perpendicular to the travelling direction of the laser beam.

Such increase in the laser beam size, means that a lower number of "sweeping" paths or trajectories of the laser beam are needed in order to cover with the predefined laser radiation 3a all the area inside the boundaries of the part to be polymerized in the layer concerned. Further, preferably, when the laser beam comes close to the external boundaries of the part defined by the image data to be polymerized, the velocity or speed of the laser beam onto surface 5 is maintained at the selected speed between about 0.5 m/s and about 3 m/s, which is the desired scanning speed (= marking speed), but the power of the laser source 3 is reduced. In this way, also the laser beam size is reduced and a more accurate polymerization can be performed at the boundaries of the image to be polymerized.

The velocity of the laser beam is changed from the marking speed only when the laser is repositioned, that is when a different area of the surface 5 needs to be polymerized, for example because the image to be polymerized in the surface 5 includes separated parts or portions which cannot be joined by a continuous line or trajectory of the laser beam 3a onto surface 5.

The speed of repositioning the laser is equal to a speed comprised between about 8 m/s and about 10 m/s, that is this speed is calculated as if the laser beam were still switched on and the speed of the spot of the beam onto the reference surface 5 would be calculated. However, in the laser repositioning, the laser source is switched off.

Preferably, the size of the laser beam onto surface 5 is comprised between 15 µm and 300 µm.

Each one of the micro-opto-electro-mechanical systems 7 and 8 described above preferably belongs to an integrated circuit provided with pins for electric connection to the machine 1, which is provided with a corresponding connector, or a socket, configured in such a way as to house said pins and also suited to allow the integrated circuit to be mechanically fixed to the machine 1.

Preferably, said connectors or sockets are of the type with low insertion force.

In variant embodiments of the invention, the micro-opto-electro- mechanical systems 7 and 8 can be directly welded onto the supporting electronic circuit, avoiding the use of the connector or the socket.

According to a variant embodiment, which is not represented in the drawings, both micro-opto-electro-mechanical systems 7 and 8 are arranged inside a single hermetically-sealed container comprising a transparent window arranged in such a way as to allow the predefined radiation 3a reflected by the micro-opto-electro-mechanical systems 7 and 8 to exit outside the container.

Advantageously, the above hermetically-sealed container results in considerable increase in lifetime of the optical unit 4.

In fact, the Applicant of the present invention has observed that the predefined laser radiation 3a causes the ambient dust to deposit on the surfaces where the radiation is incident. This effect is particularly noticeable when the predefined radiation 3a is a laser beam having frequencies in the violet range used in stereolithography of the invention of about 405 nm ± 10 nm.

The above effect is particularly prejudicial to the very small surfaces of the micro-opto-electro-mechanical systems 7 and 8, which are rapidly covered by the dust, hence causing worsening of their reflective effect. Since, due to the extreme fragility of the micro-opto-electro-mechanical systems 7 and 8, it is not possible cleaning them, the above effect must be compensated through increasing the power of the predefined radiation 3a, which nevertheless causes increased heating of the micro-opto-electro-mechanical systems 7 and 8, thus speeding up their deterioration.

The herrnetically-sealed container prevents the above effect. In particular, the transparent window can be cleaned more easily, preventing the above drawbacks.

Also advantageously, the hermetically-sealed container allows to incorporate the two micro-opto-electro-mechanical systems 7 and 8 in a single integrated circuit, preferably having a common support structure 10.

As regards the optical unit 4, this preferably comprises one or more lenses 14 configured so as to focus the radiation 3a on the reference surface 5.

Preferably, said lens 14 is of the so-called "flat field" type, which is such to focus the radiation 3a on a plane reference surface 5. Such lens 14 may include a F-theta lens or an analogous optic.

In practice, the micro-opto-electro-mechanical systems 7 and 8 are arranged in the stereolithography machine 1 in such a way that the mirrors 9 are aligned with each other and with the radiation 3a produced by the laser source 3.

Preferably, the positions of the source 3 and of the two micro-opto- electro-mechanical systems 7 and 8 are such that when the mirrors 9 are in conditions of absence of rotation, that is, when the connection areas 13 of both the micro-opto-electro-mechanical systems 7 and 8 are not subjected to torsion, the radiation 3a is reflected towards the center point of the reference surface 5.

## Claims

1. Stereolithography machine (1) comprising:
• a container (2) for a fluid substance (15) suited to be solidified through exposure to predefined radiation (3a);
• a laser source (3) apt to emit a beam of said predefined radiation (3a);
• a vector scanning optical unit (4) configured to perform a vector scanning of a reference surface (5) arranged inside said container (2) according to a desired vector data image by means of said predefined radiation;
• a memory to store said vector data image representative of an image to be scanned on said reference surface;
• a logic control unit (6) configured for controlling said vector scanning optical unit (4) and/or said laser source (3) in such a way as to expose a predefined portion of said reference surface (5) to said radiation (3a) according to said vector data image;
**wherein** said vector scanning optical unit (4) comprises a first and a second micro-opto-electro-mechanical systems (MOEMS) (7, 8) arranged in series one after the other with respect to a travelling path of said predefined radiation, each MOEMS system comprising:
• a mirror (9) having a diameter comprised between about 2 mm and about 8 mm associated with a supporting structure (10) through articulation means (11) configured so as to define for said mirror (9) a rotation axis (X1, X2);
• an actuator (12) suited to move said mirror (9) around said rotation axis (X1, X2) in a quasi-static manner at an angular speed so that a corresponding marking speed of said laser beam on said reference surface (5) is comprised between about 0.5 m/s and about 3 m/s when said laser source (3) is emitting said predetermined radiation (3a) during said vector scanning;
and wherein
• the rotation axis (X1) of the mirror (9) of the first MOEMS system (7) is not parallel to the rotation axis (X2) of the mirror (9) of the second MOEMS system (8).

2. Stereolithography machine (1) according to claim 1, wherein said actuator (12) is configured to move said mirror (9) of said first and/or second MOEMS system (7, 8) around said rotation axis (X1, X2) at an angular speed so that a corresponding positioning speed of said laser beam on said reference surface (5) is comprised between about 8m/s and about 10 m/s when said laser source (3) is not emitting said predetermined radiation (3a) to change position for the scanning of said image.

3. Stereolithography machine (1) according to claim 1 or 2, wherein said two rotation axes (X1, X2) of said first and second micro-opto-electro-mechanical systems (MOEMS) (7, 8) are mutually orthogonal.

4. Stereolithography machine (1) according to any of the preceding claims, wherein said laser source (3) is configured to emit said predefined radiation (3a) at a wavelength comprised between about 405 nm ± 10 nm.

5. Stereolithography machine (1) according to any of the preceding claims, wherein said laser source (3) is configured to emit said predefined radiation (3a) having an irradiance at the reference surface (5) comprised between about 10 mJ/cm² and about 200 mJ/cm².

6. Stereolithography machine (1) according to any of the preceding claims, including a sealed container housing said laser source (3) and said first and second micro-opto-electro-mechanical systems (MOEMS) (7, 8) arranged in series, said sealed contained including a windows realized in a material transparent to said predetermined radiation (3a) so that said radiation can exit said container.

7. Stereolithography machine (1) according to any of the preceding claims, wherein said actuator (12) of each one of said first and second micro-opto-electro-mechanical system (MOEMS) (7, 8) is of the electromagnetic or electrostatic type and is configured so as to rotate said mirror (9) around said axis (X1, X2) in such a way as to arrange it in an angular position in response to the reception of a control signal emitted by said logic control unit (6) and having a value that is representative of said angular position.

8. Stereolithography machine (1) according to any of the preceding claims, wherein said logic control unit (6) is configured so as to move said mirror (9) of both said micro-opto-electro-mechanical systems (MOEMS) (7,8) so that the point of incidence of said radiation (3a) on said reference surface (5) defines a continuous trajectory that completely covers said predefined portion according to said image data.

9. Stereolithography machine (1) according to any of the preceding claims, wherein said vector scanning optical unit (4) comprises at least one lens (14) configured so as to focus said predefined radiation (3a) on said reference surface (5).

10. Stereolithography machine (1) according to claim 9, wherein said at least one lens (14) comprises a flat field scanning lens.

11. Stereolithography machine (1) according to any of the preceding claims, wherein said fluid substance (15) includes a curable resin.

12. Stereolithography machine (1) according to any of the preceding claims, wherein said first and second micro-opto-electro-mechanical systems (MOEMS) (7, 8) belong to a common integrated circuit.

13. Stereolithography machine (1) according to any of the preceding claims, wherein said laser source (3) includes a power control (150) to vary a power of said predefined radiation (3a) emitted by said laser source (3), said power control (150) being connected to said logic control unit (6), said logic control unit being apt to change said emitted power of said predetermined radiation (3a) depending on a position of said radiation beam on said reference surface (5).

14. Stereolithography machine (1) according to claim 13, wherein said laser source power control (150) includes a size control to vary a size of said laser beam of said predefined radiation (3a) emitted by said laser source (3), said size being measured in a cross-section along a plane perpendicular to a travelling direction of said radiation.

## Patentansprüche

1. Stereolithographiemaschine (1), umfassend:
• einen Behälter (2) für eine flüssige Substanz (15), die zur Verfestigung durch Einwirkung einer vorbestimmten Strahlung (3a) geeignet ist;
• eine Laserquelle (3), die geeignet ist, um einen Strahl der vorbestimmten Strahlung (3a) zu emittieren;
• eine optische Vektorabtasteinheit (4), die eingerichtet ist, um eine Vektorabtastung einer Referenzfläche (5) durchzuführen, die im Behälter (2) gemäß einem gewünschten Vektordatenbild mittels der vorbestimmten Strahlung angeordnet ist;
• einen Speicher zum Speichern des Vektordatenbildes, das für ein abzutastendes Bild auf der Referenzfläche repräsentativ ist;
• eine Logiksteuereinheit (6), die zum Steuern der optischen Vektorabtasteinheit (4) und / oder der Laserquelle (3) derart eingerichtet ist, dass ein vorbestimmter Teil der Referenzfläche (5) der Strahlung (3a) gemäß dem Vektordatenbild ausgesetzt wird;
wobei die optische Vektorabtasteinheit (4) ein erstes und ein zweites mikro-opto-elektro-mechanisches System (MOEMS) (7, 8) aufweist, die in Bezug auf eine Bewegungsstrecke der vorbestimmten Strahlung nacheinander in Reihe angeordnet sind, wobei jedes MOEMS-System aufweist:
• einen Spiegel (9) mit einem Durchmesser zwischen ungefähr 2 mm und ungefähr 8 mm, der einer Abstützstruktur (10) durch eine Gelenkeinrichtung (11) zugeordnet ist, die so eingerichtet ist, um für den Spiegel (9) eine Rotationsachse (X1, X2) zu bestimmen;
• einen Aktuator (12), der geeignet ist, um den Spiegel (9) quasistatisch bei einer Winkelgeschwindigkeit um die Rotationsachse (X1, X2) zu bewegen, so dass eine entsprechende Markierungsgeschwindigkeit des Laserstrahls auf der Referenzfläche (5) zwischen ungefähr 0,5 m/s und ungefähr 3 m/s aufgewiesen wird, wenn die Laserquelle (3) die vorbestimmte Strahlung (3a) während der Vektorabtastung emittiert;
und wobei
• die Rotationsachse (X1) des Spiegels (9) des ersten MOEMS-Systems (7) nicht parallel zur Rotationsachse (X2) des Spiegels (9) des zweiten MOEMS-Systems (8) ist.

2. Stereolithographiemaschine (1) nach Anspruch 1, wobei der Aktuator (12) eingerichtet ist, um den Spiegel (9) des ersten und / oder zweiten MOEMS-Systems (7, 8) um die Rotationsachse (X1, X2) bei einer Winkelgeschwindigkeit zu bewegen, so dass eine entsprechende Positionierungsgeschwindigkeit des Laserstrahls auf der Referenzfläche (5) zwischen ungefähr 8 m/s und ungefähr 10 m/s aufgewiesen wird, wenn die Laserquelle (3) die vorbestimmte Strahlung (3a) zum Ändern einer Position für das Abtasten des Bildes nicht emittiert wird.

3. Stereolithographiemaschine (1) nach Anspruch 1 oder 2, wobei die beiden Rotationsachsen (X1, X2) der ersten und zweiten mikro-opto-elektro-mechanischen Systeme (MOEMS) (7, 8) orthogonal zueinander sind.

4. Stereolithographiemaschine (1) nach einem der vorhergehenden Ansprüche, wobei die Laserquelle (3) eingerichtet ist, um die vorbestimmte Strahlung (3a) bei einer Wellenlänge zwischen ungefähr 405 nm ± 10 nm zu emittieren.

5. Stereolithographiemaschine (1) nach einem der vorhergehenden Ansprüche, wobei die Laserquelle (3) eingerichtet ist, um die vorbestimmte Strahlung (3a) mit einer Bestrahlungsstärke an der Referenzfläche (5) zu emittieren, die zwischen ungefähr 10 mJ / cm² und ungefähr 200 mJ / cm² aufgewiesen wird.

6. Stereolithographiemaschine (1) gemäß einem der vorhergehenden Ansprüche mit einem versiegelten Behälter, der die Laserquelle (3) und das erste und zweite mikro-opto-elektro-mechanische System (MOEMS) (7, 8) aufnimmt, die in Reihe angeordnet sind, wobei der versiegelte Behälter ein Fenster umfasst, das aus einem für die vorbestimmte Strahlung (3a) transparenten Material hergestellt ist, so dass die Strahlung aus dem Behälter austreten kann.

7. Stereolithographiemaschine (1) nach einem der vorhergehenden Ansprüche, wobei der Aktuator (12) von jedem der ersten und zweiten mikro-opto-elektro-mechanischen Systeme (MOEMS) (7, 8) ein elektromagnetischer oder ein elektrostatischer Typ ist, und so eingerichtet ist, dass der Spiegel (9) um die Achse (X1, X2) derart gedreht wird, um ihn in einer Winkelposition als Reaktion auf den Empfang eines Steuersignals anzuordnen, das durch die Logiksteuereinheit (6) emittiert wird und einen Wert aufweist, der für die Winkelposition repräsentativ ist.

8. Stereolithographiemaschine (1) nach einem der vorhergehenden Ansprüche, wobei die Logiksteuereinheit (6) so eingerichtet ist, dass sie den Spiegel (9) beider mikro-opto-elektro-mechanischen Systeme (MOEMS) (7, 8) bewegt, so dass der Einfallspunkt der Strahlung (3a) auf der Referenzfläche (5) eine kontinuierliche Bewegungsbahn bestimmt, die den vorbestimmten Abschnitt gemäß den Bilddaten vollständig abdeckt.

9. Stereolithographiemaschine (1) nach einem der vorhergehenden Ansprüche, wobei die optische Vektorabtasteinheit (4) zumindest eine Linse (14) aufweist, die so eingerichtet ist, dass sie die vorbestimmte Strahlung (3a) auf die Referenzfläche (5) fokussiert.

10. Stereolithographie-Maschine (1) nach Anspruch 9, wobei die zumindest eine Linse (14) eine Flachfeld-Abtastlinse aufweist.

11. Stereolithographiemaschine (1) nach einem der vorhergehenden Ansprüche, wobei die flüssige Substanz (15) ein härtbares Harz umfasst.

12. Stereolithographiemaschine (1) nach einem der vorhergehenden Ansprüche, wobei die ersten und zweiten mikro-opto-elektro-mechanischen Systeme (MOEMS) (7, 8) zu einer gemeinsamen integrierten Schaltung gehören.

13. Stereolithographiemaschine (1) nach einem der vorhergehenden Ansprüche, wobei die Laserquelle (3) eine Leistungssteuerung (150) umfasst, um eine Leistung der vorbestimmten Strahlung (3a) zu variieren, die von der Laserquelle (3) emittiert wird, wobei die Leistungssteuerung (150) mit der Logiksteuereinheit (6) verbunden ist, wobei die Logiksteuereinheit geeignet ist, um die emittierte Leistung der vorbestimmten Strahlung (3a) in Abhängigkeit einer Position des Strahlungsstrahls auf der Referenzfläche (5) zu ändern.

14. Stereolithographiemaschine (1) nach Anspruch 13, wobei die Laserquellenleistungssteuerung (150) eine Dimensionssteuerung umfasst, um eine Dimension des Laserstrahls der von der Laserquelle (3) emittierten vorbestimmten Strahlung (3a) zu variieren, wobei die Dimension in einem Querschnitt entlang einer Ebene senkrecht zu einer Bewegungsrichtung der Strahlung gemessen wird.

## Revendications

1. Machine de stéréolithographie (1) comprenant :
- un récipient (2) pour une substance fluide (15) adaptée pour être solidifiée par exposition à un rayonnement prédéfini (3a) ;
- une source laser (3) apte à émettre un faisceau dudit rayonnement prédéfini (3a) ;
- une unité optique à balayage vectoriel (4) configurée pour effectuer un balayage vectoriel d'une surface de référence (5) agencée à l'intérieur dudit récipient (2) en fonction d'une image de données vectorielles souhaitée au moyen dudit rayonnement prédéfini ;
- une mémoire pour stocker ladite image de données vectorielles représentative d'une image devant être balayée sur ladite surface de référence ;
- une unité de commande logique (6) configurée pour commander ladite unité optique à balayage vectoriel (4) et/ou ladite source laser (3) de manière à exposer une partie prédéfinie de ladite surface de référence (5) audit rayonnement (3a) en fonction de ladite image de données vectorielles ;
dans laquelle ladite unité optique à balayage vectoriel (4) comprend un premier et un second microsystèmes optoélectromécaniques (MOEMS) (7, 8) agencés en série l'un après l'autre par rapport à une trajectoire de déplacement dudit rayonnement prédéfini, chaque système MOEMS comprenant :
- un miroir (9) ayant un diamètre compris entre environ 2 mm et environ 8 mm associé à une structure de support (10) par le biais de moyens d'articulation (11) configurés de sorte à définir pour ledit miroir (9) un axe de rotation (X1, X2) ;
- un actionneur (12) adapté pour déplacer ledit miroir (9) autour dudit axe de rotation (X1, X2) de manière quasi-stationnaire à une vitesse angulaire de sorte à ce qu'une vitesse de marquage correspondante dudit faisceau laser sur ladite surface de référence (5) est comprise entre environ 0,5 m/s et environ 3 m/s lorsque ladite source laser (3) émet ledit rayonnement prédéterminé (3a) au cours dudit balayage vectoriel ;
et dans laquelle
- l'axe de rotation (X1) du miroir (9) du premier système MOEMS (7) n'est pas parallèle à l'axe de rotation (X2) du miroir (9) du second système MOEMS (8).

2. Machine de stéréolithographie (1) selon la revendication 1, dans laquelle ledit actionneur (12) est configuré pour déplacer ledit miroir (9) dudit premier et/ou second système MOEMS (7, 8) autour dudit axe de rotation (X1, X2) à une vitesse angulaire de sorte qu'une vitesse de positionnement correspondante dudit faisceau laser sur ladite surface de référence (5) est comprise entre environ 8 m/s et environ 10 m/s lorsque ladite source laser (3) n'émet pas ledit rayonnement prédéterminé (3a) pour modifier la position pour le balayage de ladite image.

3. Machine de stéréolithographie (1) selon la revendication 1 ou 2, dans laquelle lesdits deux axes de rotation (X1, X2) desdits premier et second microsystèmes optoélectromécaniques (MOEMS) (7, 8) sont mutuellement orthogonaux.

4. Machine de stéréolithographie (1) selon l'une quelconque des revendications précédentes, dans laquelle ladite source laser (3) est configurée pour émettre ledit rayonnement prédéfini (3a) à une longueur d'onde comprise entre environ 450 nm ± 10 nm.

5. Machine de stéréolithographie (1) selon l'une quelconque des revendications précédentes, dans laquelle ladite source laser (3) est configurée pour émettre ledit rayonnement prédéfini (3a) ayant une irradiance au niveau de la surface de référence (5) comprise entre environ 10 mJ/cm² et environ 200 mJ/cm².

6. Machine de stéréolithographie (1) selon l'une quelconque des revendications précédentes, incluant un récipient scellé logeant ladite source laser (3) et lesdits premier et second microsystèmes optoélectromécaniques (MOEMS) (7, 8) agencés en séries, ledit récipient scellé incluant une fenêtre réalisée dans un matériau transparent audit rayonnement prédéterminé (3a) de telle sorte que ledit rayonnement peut sortir dudit récipient.

7. Machine de stéréolithographie (1) selon l'une quelconque des revendications précédentes, dans laquelle ledit actionneur (12) de chacun desdits premier et second microsystème optoélectromécanique (MOEMS) (7, 8) est du type électromagnétique ou électrostratique et est configuré de sorte à faire tourner ledit miroir (9) autour dudit axe (X1, X2) de manière à l'agencer dans une position angulaire en réponse à la réception d'un signal de commande émis par ladite unité de commande logique (6) et ayant une valeur qui est représentative de ladite position angulaire.

8. Machine de stéréolithographie (1) selon l'une quelconque des revendications précédentes, dans laquelle ladite unité de commande logique (6) est configurée de sorte à déplacer ledit miroir (9) des deux dits microsystèmes optoélectromécaniques (MOEMS) (7, 8) de telle sorte que le point d'incidence dudit rayonnement (3a) sur ladite surface de référence (5) définit une trajectoire continue qui couvre complètement ladite partie prédéfinie en fonction desdites données d'image.

9. Machine de stéréolithographie (1) selon l'une quelconque des revendications précédentes, dans laquelle ladite unité optique à balayage vectoriel (4) comprend au moins une lentille (14) configurée de sorte à focaliser ledit rayonnement prédéfini (3a) sur ladite surface de référence (5).

10. Machine de stéréolithographie (1) selon la revendication 9, dans laquelle ladite au moins une lentille (14) comprend une lentille de balayage à champ plat.

11. Machine de stéréolithographie (1) selon l'une quelconque des revendications précédentes, dans laquelle ladite substance fluide (15) inclut une résine durcissable.

12. Machine de stéréolithographie (1) selon l'une quelconque des revendications précédentes, dans laquelle lesdits premier et second microsystèmes optoélectromécaniques (MOEMS) (7, 8) appartiennent à un circuit intégré commun.

13. Machine de stéréolithographie (1) selon l'une quelconque des revendications précédentes, dans laquelle ladite source laser (3) inclut une commande de puissance (150) pour faire varier une puissance dudit rayonnement prédéfini (3a) émis par ladite source laser (3), ladite commande de puissance (150) étant connectée à ladite unité de commande logique (6), ladite unité de commande logique étant apte à modifier ladite puissance émise dudit rayonnement prédéterminé (3a) en fonction d'une position dudit faisceau de rayonnement sur ladite surface de référence (5).

14. Machine de stéréolithographie (1) selon la revendication 13, dans laquelle ladite commande de puissance de source laser (150) inclut une commande de taille pour faire varier une taille dudit faisceau laser dudit rayonnement prédéfini (3a) émis par ladite source laser (3), ladite taille étant mesurée dans une section transversale le long d'un plan perpendiculaire à une direction de déplacement dudit rayonnement.
